# EUROPÄISCHE PATENTSCHRIFT

(11) **EP 0 788 661 B1**
(45) Veröffentlichungstag und Bekanntmachung des Hinweises auf die Patenterteilung: **16.06.1999**
(21) Anmeldenummer: 95931950.0
(22) Anmeldetag: 31.08.1995
(51) Int. Cl.: H01L 31/105, H01L 25/04

(54) **DREIFARBENSENSOR**
THREE-COLOUR SENSOR
CAPTEUR DE TROIS COULEURS

(30) Priorität: 30.10.1994 DE 4441444
(43) Veröffentlichungstag der Anmeldung: 13.08.1997
(73) Patentinhaber: BÖHM, Markus, 57068 Siegen (DE)
(72) Erfinder: BÖHM, Markus, 57068 Siegen (DE)
(74) Vertreter: Cohausz & Florack
(86) Internationale Anmeldenummer: EP9503421
(87) Internationale Veröffentlichungsnummer: WO9613865

(56) Entgegenhaltungen:
- US-A- 5 311 047
- AMORPHOUS SILICON TECHNOLOGY - 1994. SYMPOSIUM, AMORPHOUS SILICON TECHNOLOGY - 1994. SYMPOSIUM, SAN FRANCISCO, CA, USA, 4-8 APRIL 1994, 1994, PITTSBURGH, PA, USA, MATER. RES. SOC, USA, Seiten 843-848, ZHU Q ET AL 'A novel a-Si(C):H color sensor array'
- IEEE ELECTRON DEVICE LETTERS, AUG. 1987, USA, Bd. EDL-8, Nr. 8, ISSN 0741-3106, Seiten 365-367, TSAI H -K ET AL 'An amorphous SiC/Si two-color detector'
- IEEE ELECTRON DEVICE LETTERS, APRIL 1991, USA, Bd. 12, Nr. 4, ISSN 0741-3106, Seiten 172-174, FANG Y K ET AL 'A vertical-type a-Si:H back-to-back Schottky diode for high-speed colour image sensor'
- SENSORS AND CONTROL FOR AUTOMATION, FRANKFURT, GERMANY, 22-24 JUNE 1994, Bd. 2247, ISSN 0277-786X, PROCEEDINGS OF THE SPIE - THE INTERNATIONAL SOCIETY FOR OPTICAL ENGINEERING, 1994, USA, Seiten 301-310, QI ZHU ET AL 'New type of thin film color image sensor' in der Anmeldung erwähnt
- APPLIED PHYSICS LETTERS, 25 JAN. 1988, USA, Bd. 52, Nr. 4, ISSN 0003-6951, Seiten 275-277, HSIUNG-KUANG TSAI ET AL 'Amorphous SiC/Si three-color detector' in der Anmeldung erwähnt
- IEEE TRANSACTIONS ON ELECTRON DEVICES, MAY 1995, USA, Bd. 42, Nr. 5, pt.1, ISSN 0018-9383, Seiten 835-840, DE CESARE G ET AL 'Tunable photodetectors based on amorphous Si/SiC heterostructures'

## Beschreibung

Die Erfindung betrifft ein photoempfindliches elektronisches Bauelement auf der Basis von amorphem Silizium und dessen Legierungen gebildet aus einer auf einem transparenten leitfähigen Oxid (TCO) abgeschiedenen Schichtenfolge, die aus zwei antiseriell zueinander angeordneten p-i-n bzw. n-i-p bzw. Schottkykontakt-Strukturen besteht, wobei im Bereich der vom transparenten Oxid aus ersten Struktur die von blauem Licht generierten Ladungsträger für eine erste Spannung und im Bereich der vom transparenten Oxid aus zweiten Struktur die von grünem bzw. rotem Licht generierten Ladungsträger für eine zweite bzw. dritte Spannung gesammelt werden, und wobei die eigenleitende Schicht der zweiten Struktur aus zwei Teilschichten aufgebaut ist sowie ein hierauf gerichtetes Herstellungsverfahren.

Ein Bauelement bzw. ein Verfahren dieser Art ist bekannt aus "Applied Physics Letters", Bd. 52, Nr. 4, New York, US, S. 275-277; H.-K. Tsai und S.-C. Lee: "Amorphous SiC/Si three-color detector". Bei diesem bekannten Bauelement wird eine Selektivität für grünes bzw. rotes Licht durch geänderte Wachstumsbedingungen der Teilschichten erreicht.

Ein photoempfindliches elektronisches Bauelement ähnlicher Art, dessen eigenleitende Schicht der zweiten Struktur jedoch nicht unterteilt ist, ist aus dem Aufsatz "New type of thin film colour image sensor", Q. Zhu, H. Stiebig, P. Rieve, J. Giehl, M. Sommer, M. Böhm, Conference Europto - Sensors and Control for Advanced Automation II, Frankfurt am Main, 20.-24. Juni 1994 bekannt.

Schließlich ist aus "IEEE Transactions on Electron Devices, Bd. 42, Nr. 5 (Mai 1995), New York, US, S. 835-840; G. de Cesare et al.: "Tunable photodetectors based on amorphous Si/SiC heterostructures" ein Bauelement bekannt, welches ebenfalls nur für zwei Farben empfindlich ist.

Photoempfindliche elektronische Bauelemente auf der Basis von amorphem Silizium (a-Si:H) haben gegenüber Bauelementen aus kristallinem Silizium den Vorteil einer wesentlich größeren Absorption für sichtbares Licht. Grundsätzlich besteht ein solches photoempfindliches elektronisches Bauelement aus zwei antiseriell zueinander geschalteten PIN Dioden, wobei die Alternativen NIPIN bzw. PINIP bekannt sind, oder aus zwei antiseriell zueinander geschalteten Metall-Halbleiterübergängen (Schottkykontakten).

Technologisch wird ein solches Bauelement durch Abscheiden'von einer Vielzahl von a-Si:H Schichten bei niedrigen Temperaturen (typischerweise 250°C) mittels des PECVD (Plasma Enhanced Chemical Vapor Deposition) Prozesses hergestellt. Das Abscheiden erfolgt zunächst z.B. auf ein isolierendes Substrat, üblicherweise Glas, unter Einschaltung einer lichtdurchlässsigen leitfähigen Oxidschicht (TCO), die später einen elektrischen Kontakt für eine von außen an das Bauelement anzulegende äußere Spannung bilden. Beim PECVD Reaktor wird durch Anlegen eines Wechselfeldes ein Plasma erzeugt, indem das Gas SiH₄ (Silan) in Siliziumradikale und Wasserstoff zerlegt wird. Dabei schlägt sich Silizium als amorpher wasserstoffhaltiger Film auf dem Substrat nieder. Ausgehend davon kann durch Zusatz von Phosphin eine n-dotierte Schicht bzw. durch Zusatz von Diboran eine p-dotierte Schicht erzeugt werden. Darüber hinaus ist es bekannt, durch Zusatz von Methan (CH₄) zum Silan den Bandabstand des amorphen Siliziums zu vergrößern bzw. durch Zusatz von German (Ge H₄) zu verkleinern.

Das auf diese Weise hergestellte Multilayerbauelement mit der gewünschten Schichtenfolge wird nunmehr so von sichtbarem Licht durchstrahlt, daß die Einfallsrichtung des Lichtes senkrecht zur Schichtebene ist. Aufgrund der Abhängigkeit des Absorptionskoeffizienten des Sensormaterials von der Wellenlänge des einfallenden Lichtes und des Bandabstandes des Sensormaterials resultiert eine unterschiedliche Eindringtiefe von Licht in das Halbleitermaterial. Dies führt dazu, daß blaues Licht (Wellenlänge ca. 450 nm) eine wesentlich kürzere Eindringtiefe (Absorptionslänge) hat als grünes oder rotes Licht. Durch entsprechende Auswahl von Größe und Polarität der äußeren am Bauelement anliegenden Gleichspannung und damit des inneren elektrischen Feldes läßt sich eine spektrale Sensibilität des Bauelementes erreichen. Beispielsweise kann durch das Anlegen entsprechender Spannungen an das Element eine Sensibilität für RGB Licht (Rot, Grün, Blau) in der Multilayerstruktur erreicht werden. Dabei wird die Hauptsammelregion der lichterzeugten Ladungsträger entlang der Länge des Bauelementes und damit dessen spektrale Empfindlichkeit in Abhängigkeit von der angelegten äußeren Spannung verschoben.

Zur Optimierung einer NIPIN Struktur in bezug auf einen Dreifarbensensor ist es aus dem oben genannten Bericht bekannt, auf beiden Seiten der p-dotierten Zwischenschicht zusätzliche eigenleitende Defektschichten vorzusehen, in deren Dickenbereich der Bandabstand gegenüber den übrigen eigenleitenden Schichten erhöht ist (z.B. von 1,74 eV auf 1,9 eV). Dies führt zu einer verbesserten Grün-/Blau-Trennung, in der in Lichteinfallsrichtung vorgeordneten NIP Struktur bzw. zu einer verbesserten Rot-/Grün-Trennung in der in Lichteinfallsrichtung nachgeordneten PIN Struktur ("sog. band-gap engineering").

Aus dem US-Patent 53 11 047 ist ein photoempfindliches elektronisches Bauelement auf der Basis von amorphem Silizium mit NIPIN Struktur bekannt.

Aus Applied Physics Letters 52(4) 1988, 275-277 ist ein heterojunction Bauelement (Phototransistor) vom NIPIN Typ bekannt, welcher zwei zusätzlich eingefügte eigenleitende Schichten aufweist. Hieraus ist bekannt, daß im ersten Übergang vorzugsweise blaues Licht und im zweiten Übergang vorzugsweise grünes oder rotes Licht absorbiert wird. Die zweite eigenleitende Schicht dient dabei zur Erhöhung der Blauabsorption.

Der Erfindung liegt die Aufgabe zugrunde, ein elektronisches Bauelement der eingangs genannten Art sowie ein Verfahren zu seiner Herstellung anzugeben, welches gewährleistet, daß unter kostengünstigen Herstellungsbedingungen ein für RGB Farben sensitives Bauelement geschaffen wird, welches über eine hohe spektrale Trennung für die RGB Farben ohne nennenswerte Infrarot/Ultraviolettbeiträge zum Ausgangssignal verfügt.

Diese Aufgabe wird erfindungsgemäß dadurch gelöst, daß in der vom transparenten Oxid aus ersten Teilschicht ein höheres und in der zweiten Teilschicht ein demgegenüber mindestens um den Faktor 10 niedrigeres Produkt aus Ladungsträgerbeweglichkeit und Lebensdauer (µ-Tau-Produkt) vorliegt derart, daß die beiden Teilschichten in Gegenwart eines elektrischen Feldes unterschiedliche Sammellängen für die Ladungsträger aufweisen dahingehend, daß in der ersten Teilschicht vermehrt grünes und in der zweiten Teilschicht vermehrt rotes Licht absorbiert wird.

Die Erfindung zeichnet sich dadurch aus, daß durch die Aufteilung mindestens einer der beiden eigenleitenden Schichten des Bauelementes in zwei Teilschichten die Blau-/ Grün-Trennung bzw. die Grün-/Rot-Trennung verbessert werden. Im Gegensatz zu bekannten Verfahren, (d.h. durch Beeinflussung des Absorptions- bzw. Rekombinationsverhaltens durch partielle Erhöhung des Bandabstandes, "band-gap engineering") bzw. durch Einbau von zusätzlichen Defektschichten weist die erfindungsgemäße Variation des µ-Tau-Produktes den entscheidenden Vorteil auf, daß eine wesentlich bessere spektrale Trennung und das gewünschte lineare Verhalten ermöglicht werden.

Hierdurch können sowohl bei hohen als auch bei niedrigen Lichtintensitäten die Grundfarben sicher getrennt werden. Durch die erfindungsgemäße Lösung ergibt sich ein Bauelement, bei dem der Zusammenhang zwischen dem Photostrom für den jeweiligen Spektralpeak und dem Photonenfluß linear ist, und zwar über mehrere Größenordnungen des Photonenflusses. Darüber hinaus sind die Spektralpeaks voneinander linear unabhängig. Durch die Linearität einerseits und die lineare Unabhängigkeit der Spektralpeaks andererseits wird ermöglicht, daß ein solches Bauelement überhaupt praktisch zur Erkennung von Farben unter unterschiedlichen Beleuchtungsbedingungen verwendet werden kann.

Durch den Einbau eines Bereichs mit niedriger, freier Beweglichkeit der Ladungsträger in der in Lichteinfallsrichtung hinteren Struktur können Ladungsträger erst bei betragsmäßig höherer Spannung und damit höherem elektrischen Feld extrahiert werden. Löcher, die durch Licht geringer Wellenlänge im vorderen Teil generiert werden, driften zur Zwischenschicht. Die Elektronen erreichen die Randschicht der hinteren Struktur, da keine Rekombinationspartner im hinteren Teil generiert werden. Langwelliges Licht (rot) generiert vorwiegend in diesem Bereich, so daß als Folge des niedrigeren µ-Tau-Produktes die Ladungsträger rekombinieren. Erst bei höheren Feldstärken können die Löcher zur Zwischenschicht driften. Dadurch erfolgt eine Rot-/Grün-Trennung in der hinteren Struktur.

Beim Einbau von geeigneten Materialien und Legierungen (z. B. a-Si:H/a-SiₓGe₍₁₋ₓ₎:H) mit unterschiedlichen freien Beweglichkeiten in den Bändern können in dieser Teilschicht Ladungsträger wegen des geringeren µ-Tau-Produktes bei kleineren Spannungen schlechter eingesammelt werden. Demgegenüber können diese Ladungsträger bei höheren Spannungen bevorzugt eingesammelt werden.

In der Teilschicht mit dem höheren µ-Tau-Produkt werden bevorzugt grüne Photonen eingesammelt, während in dem in Lichteinfallsrichtung nachgeordneten hinteren Bereich bevorzugt die roten Ladungsträger eingesammelt werden. Aufgrund der unterschiedlichen wellenlangenabhängigen Brechungsindizes von a-Si:H/a-Si(C):H und a-SiₓGe₁₋ₓ:H läßt sich für die vordere Teil schicht der nachgeordneten eigenleitenden Schicht ein Bereich bestimmter Dicke ermitteln, in dem mehr grüne als rote Photonen absorbiert werden. Die generierten Ladungsträger lassen sich bei kleineren negativen Spannungen extrahieren und bestimmen das Maximum der spektralen Empfindlichkeit. Bei höheren negativen Spannungen wird das Maximum der spektralen Empfindlichkeit durch die Ladungsträger bestimmt, die in der hinteren Teilschicht dieser eigenleitenden Schicht generiert werden.

Das Maximum der spektralen Ampfindlichkeit für langwelligeres Licht läßt sich durch die Schichtdicke des SiₓGe₁₋ₓ Materials, den Germaniumanteil in diesem Bereich und eventuell eine Gradierung einstellen.

Im Ergebnis können bei dem erfindungsgemäßen Bauelement somit durch Anlegen dreier verschiedener Spannungen drei unterschiedlich tief im Bauelement liegende Raumladungszonen erhalten werden, so daß sich die hervorragende Spektralselektivität ergibt. Ein besonderer Vorteil besteht darin, daß sich eine Linearität über fünf Größenordnungen der Beleuchtungsstärke ergibt. Darüber hinaus verfügt das erfindungsgemäße Bauelement über einen niedrigen Dunkelstrom und einen hohen Dynamikbereich (> 120 dB, bezogen auf 1000 lux). Ein weiterer Vorteil besteht darin, daß die spektrale Empfindlichkeit kundenspezifisch vorgebbar ist. Von besonderer Bedeutung ist, daß die Selektion der Spektralanteile ohne die Verwendung zusätzlicher optischer Filter möglich ist.

Bevorzugte Ausführungsformen sind in den Unteransprüchen aufgeführt.

Als bevorzugte Varianten von photoempfindlichen Bauelementen kommen eine NIPIN oder eine PINIP Struktur in Frage, die erfindungsgemäß durch die Teilschichten unterschiedlichen µ-Tau-Produktes modifiziert sind. Technologisch wird die µ-Tau Variation bevorzugt durch Einlegieren von Germanium in das amorphe Silizium erreicht (a-SiₓGe₁₋ₓ:H).

Zur Verbesserung der Blau-/Rot-Trennung sowie zur Verbesserung der Quantenausbeute kann die eigenleitende Schicht der in Lichteinfallsrichtung vorderen Struktur aus einer karbonierten Schicht (a-Si(C):H) bestehen, so daß zusätzlich zur µ-Tau Optimierung auch eine Anpassung des Bandabstandes erfolgt.

Die besonders bevorzugte Ausführungsform der Erfindung sieht vor, daß das Bauelement Teil eines Farbsensors ist, in dem die das Bauelement bildende Schichtstruktur auf der Oberfläche eines integrierten Schaltkreises angeordnet ist. Hierdurch ergibt sich durch die Kombination eines kristallinen Bauelementes (beispielsweise eines ASICS) mit dem nach der Niedrigtemperatur-PECVD-Technologie hergestellten Multischichtbauelement eine einfache und kostengünstig herstellbare Kombination, die als Farbbildsensor eine hohe Auflösung aufweist. Dabei wirkt jedes Flächenelement des photoempfindlichen Bauelementes entsprechend der Mikrostruktur des integrierten Schaltkreises oder des ASICS als einzelnes Pixelelement. Durch die im Bereich der Pixelfläche anliegende, vom Schaltkreis vorgebbare Spannung wird die Farbselektivität eingestellt. Hierdurch entsteht ein sogenanntes "Thin Film On ASIC" (TFA) Sensorsystem, welches die Vorteile von herkömmlichen ASICS aus kristallinem Silizium und einem optischen Sensor auf der Grundlage amorphen Siliziums verbindet.

Die Erfindung wird im folgenden anhand einer Zeichnung näher erläuter:

Dabei zeigen:
- Fig. 1: eine Prinzipskizze zur Erläuterung des Schichtenaufbaus eines photoempfindlichen elektronischen Bauelementes gemäß Stand der Technik
- Fig. 2: eine Prinzipskizze zur Erläuterung der Wirkungsweise des Elements nach Fig. 1, wobei
- Fig. 2a: die räumliche Anordnung der einzelnen Schichten des Vielschichtbauelementes,
- Fig. 2b: den örtlichen Verlauf der elektrischen Feldstärke bei U>0 und
- Fig. 2c: den örtlichen Verlauf der elektrischen Feldstärke bei U<0
- Fig. 3: eine Prinzipsskizze zur Erläuterung des Schichtenaufbaus eines photoempfindlichen elektronischen Bauelementes gemäß Erfindung
- Fig. 4: eine Prinzipskizze zur Erläuterung der Wirkungsweise des Elementes nach Fig. 3, wobei
- Fig. 4a: die räumliche Anordnung der einzelnen Schichten des Vielschichtbauelementes,
- Fig. 4b: den örtlichen Verlauf der elektrischen Feldstärke bei U>0,
- Fig. 4c: den örtlichen Verlauf der elektrischen Feldstärke bei U<0 sowie den örtlichen Verlauf des µ-Tau-Produktes und
- Fig. 5: eine Prinzipskizze zur Erläuterung des Schichtenaufbaus der Kombination eines photoempfindlichen elektronischen Bauelementes gemäß der Erfindung mit einem integrierten Schaltkreis.

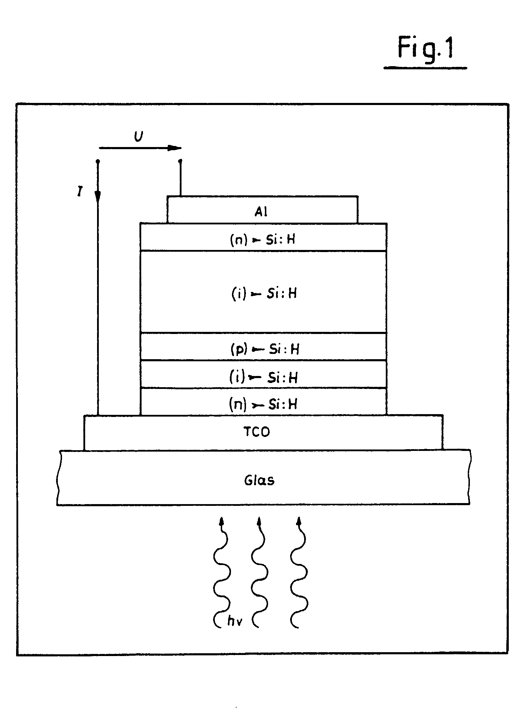

In Fig. 1 ist der Querschnitt durch NIPIN Schichtsystem dargestellt, bei dem die NIPIN Schichtenfolge auf einem Träger (Glas) abgeschieden ist. Das Glassubstrat wird anschließend mit einer TCO-Schicht bestehend aus einem lichtdurchlässigen leitfähigen Oxid beschichtet und darauf werden dann entsprechend der in Fig. 1 dargestellten Folge die einzelnen amorphen Siliziumschichten abgeschieden.

Der Abscheidungsprozeß erfolgt mittels der bekannten PECVD-Technologie, bei der amorphes Silizium bei relativ niedrigen Temperaturen (ca. 250°C) in der gewünschten Schichtdicke abgeschieden wird.

Den Rückkontakt bildet eine Aluminiumelektrode, an die eine äußere elektrische Spannung U angelegt wird, die einen in das Element fließendenden Strom I treibt, wobei die TCO-Schicht das Bezugspotential bildet. Hierdurch wirkt die Anordnung wie eine antiseriell geschaltete Kombination zweier PIN Dioden.

Wie ferner in Fig. 1 dargestellt ist, erfolgt der Lichteinfall durch das Glassubstrat in das NIPIN Schichtsystem senkrecht zu den Schichtoberflächen.

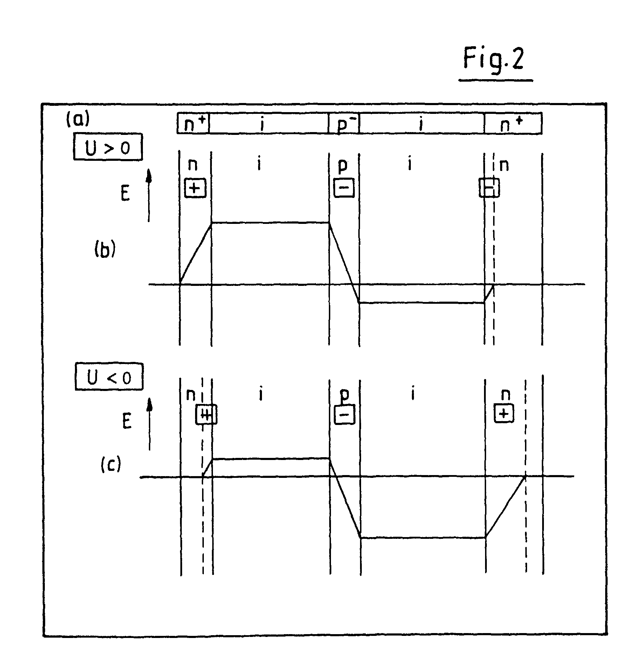

Die Halbleiterstruktur ist in Fig. 2a skizziert dargestellt. In den die Randschichten des NIPIN Bauelementes bildenden n dotierten Bereichen liegt eine starke Dotierung vor. In diesen Bereichen findet keine Ladungsträgersannlung statt, da eine hohe Rekombinationswahrscheinlichkeit zwischen Elektronen und Löchern entsprechend den hohen Defektdichten vorliegt. Wegen der als konstant angenommenen Dotierungskonzentration erfolgt dort, wie in Fig. 2b bzw. Fig. 2c dargestellt ist, ein linearer Anstieg der elektrischen Feldstärke. In den als raumladungsfrei angenommenen eigenleitenden Bereichen herrscht eine räumlich ungefähr konstante Verteilung der elektrischen Feldstärke, wobei der Beitrag zur Raumladung durch bewegliche Ladungsträger, Defekte und Störstellen vernachlässigt wird. Photogenerierte Ladungsträger werden als primärer Photostrom mittels des elektrischen Feldes gesammelt. Thermisch erzeugte Ladungsträger tragen zu dem Dunkelstrom bei. Da die NIPIN Struktur als zwei antiseriell geschaltete PIN Dioden betrachtet werden kann, findet der Hauptabfall der Spannung im Bereich der in Sperrichtung gepolten Diode statt. Das elektrische Feld in der in Durchlaßrichtung gepolten Diode ist demgegenüber vernachlässigbar. Die im Bereich der mittleren p-Schicht vorhandene Raumladungsdichte ist, wie aus den Fig. 2b und 2c hervorgeht, unter der Voraussetzung der Vernachlässigung von thermisch erzeugten Ladungsträgern eine Funktion der angelegten Spannung U, wobei im Mittelbereich der p-Zwischenschicht an einer bestimmten Stelle die Feldstärke einen Nulldurchgang hat.

In Abhängigkeit von der außen am Element anliegenden Spannung ergibt sich der Verlauf der elektrischen Feldstärke entweder gemäß Fig. 2b (U>0) oder gemäß Fig. 2c (U<0). Wird nun gemäß Fig. 2b eine positive Spannung, beispielsweise +2 Volt, an das in Fig. 1 dargestellte Element angelegt, ist die vordere Diode in Sperrichtung gepolt, so daß sich in ihr ein hohes elektrisches Feld ausbildet, in dem Ladungsträger getrennt werden können. Da dieser Bereich in Lichteinfallsrichtung vorne liegt, werden dort die spektralen Anteile des Lichtes mit niedriger Absorptionslänge, d.h. blaues Licht, absorbiert.

Wenn umgekehrt an das Bauelement eine negative Spannung angelegt wird, bildet sich die Raumladungszone im Bereich der hinteren PIN Diode aus, so daß dort das Licht im grünen bzw. roten Spektralbereich absorbiert wird, welches eine größere Eindringtiefe aufweist.

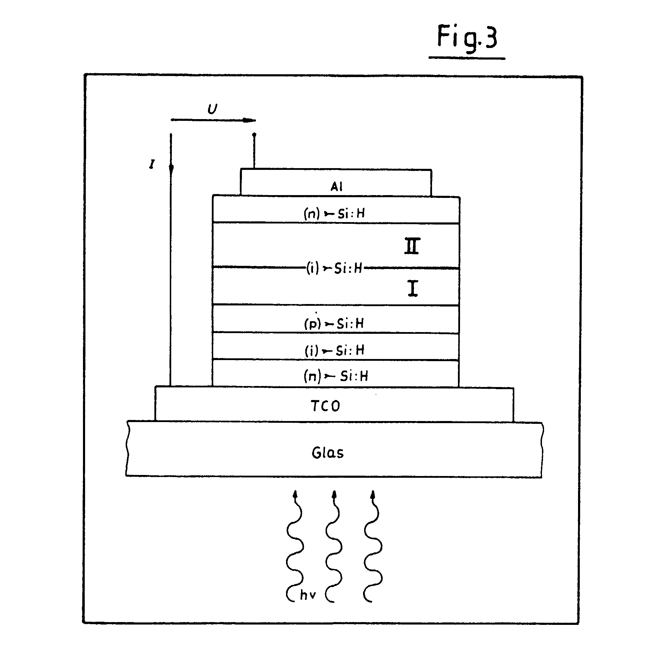

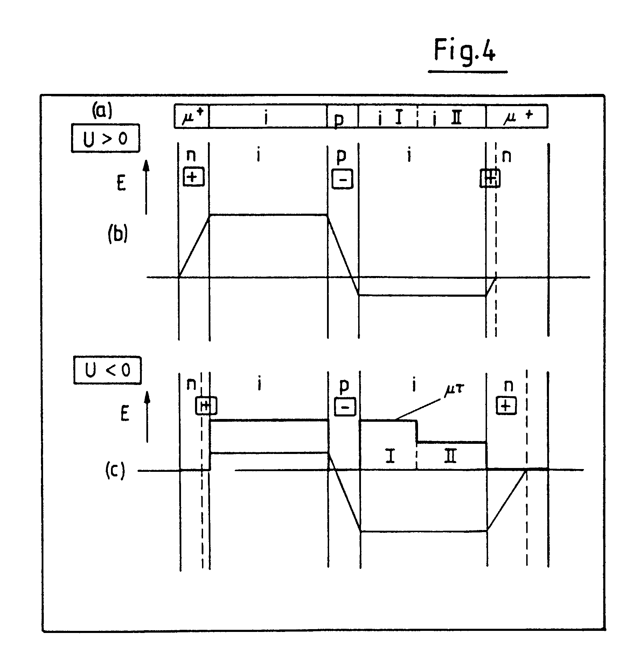

Ausgehend davon zeigt Fig. 3 ein Ausführungsbeispiel für ein photoempfindliches elektronisches Bauelement gemäß der Erfindung. In Ergänzung zu dem im Zusammenhang mit Fig. 1 dargestellten Bauelement ist gemäß Fig. 3 die in Lichteinfallsrichtung hintere eigenleitende Schicht in zwei Teilschichten I, II unterteilt. Die Unterteilung erfolgt dahingehend, daß in der Teilschicht I ein größeres µ-Tau-Produkt vorliegt als in der Teilschicht II. Dieser Zusammenhang geht aus Fig. 4c durch die als dicke Linie gezeichnete µ-Tau-Kennlinie hervor, aus der die Abstufung in den Bereichen I, II erkennbar ist.

Dies führt bei ansonsten entsprechenden Grundfunktionen des Bauelementes zu folgender Wirkungsweise:

Entsprechend Fig. 4b werden durch blaues Licht generierte Ladungsträger wiederum dann bevorzugt absorbiert, wenn am Bauelement eine positive äußere Spannung anliegt.

Fig. 4c zeigt demgegenüber den Fall, daß am Bauelement eine negative Spannung U anliegt. Dabei soll zunächst der Fall betrachtet werden, daß die negative Spannung betragsmäßig vergleichsweise gering ist, beispielsweise eine Spannung von -0,5 Volt am Bauelement anliegt. Durch den Einbau von Materialien mit niedrigeren freien Beweglichkeiten im hinteren Bereich der zweiten eigenleitenden Schicht (Teilschicht II) und daraus resultierenden geringeren µ-Tau-Produkt kann eine Einsammlung von Ladungsträgern, die von Licht großer Eindringtiefe (dem roten Licht entsprechend) erzeugt werden, schlechter stattfinden. Daher werden bei einer solchen Spannung bevorzugt Ladungsträger, die von grünen Photonen generiert werden, eingesammelt. Da die Teilschicht I nicht mit Germanium versetzt ist, ist der Bandabstand dort auch so hoch, daß rote Photonen nicht oder nur ungenügend absorbiert werden können.

Wenn demgegenüber die negative Spannung betragsmäßig steigt, können bevorzugt rote Ladungsträger eingesammelt werden. Aufgrund des in der Teilschicht II außerdem niedrigen Bandabstandes infolge der Versetzung der Schicht mit Germanium werden dort rote Photonen besonders gut absorbiert.

Somit ergibt sich durch die Abstufung des µ-Tau-Produktes im Bereich der hinteren eigenleitenden Schicht eine erheblich verbesserte Rot-/Grün-Trennung und somit in Kombination mit der im Bereich der vorderen eigenleitenden Schicht erfolgenden Blauabsorption die Möglichkeit eines Dreifarbensensors mit sehr hoher Selektivität.

Ausgehend von den oben beschriebenen Grundfunktionen des erfindungsgemäßen Bauelementes können noch folgende Verbesserungen bevorzugt vorgesehen sein:

Die eigenleitende Schicht der in Lichteinfallsrichtung vorgeordneten NIP-Diode kann aus einer karbonierten Schicht bestehen, so daß sich eine verbesserte Blau-/Rot-Separation ergibt. Zur Herabsetzung des Dunkelstroms kann innerhalb dieser eigenleitenden Schicht ein Bereich mit einem geringeren Bandabstand vorgesehen sein.

Zur Verbesserung der maximalen Quantenausbeute kann die n-Schicht der in Lichteinfallsrichtung vorgeordneten Struktur karboniert oder als mikrokristalline Schicht ausgeführt sein, wobei auch die mittlere p-Schicht karboniert sein kann.

Zusätzlich kann die Empfindlichkeit der ersten Struktur hinsichtlich der Blauabsorption durch eine geringfügige Dotierung im Übergangsbereich zwischen der eigenleitenden und der mittleren p-Schicht zu kleineren Wellenlängen hin verschoben werden.

Zur Optimierung der spektralen Selektivität können eine graduierte a-SiₓGE₁₋ₓ:H Schicht oder weitere undotierte Schichten hinter oder vor der a-SiₓGE₁₋ₓ:H Schicht angebracht werden.

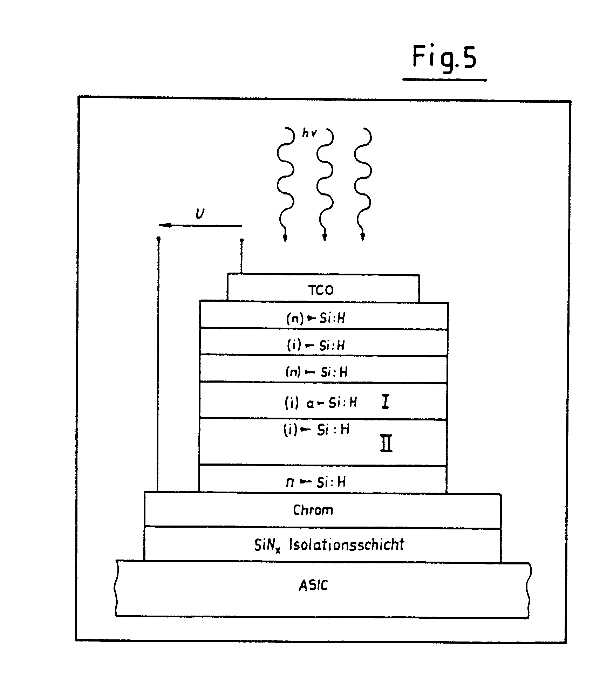

Ausgehend von dem Zusammenhang mit Fig. 3 beschriebenen Bauelement kann ein in Fig. 5 dargestellter Farbbildsensor erstellt werden, in dem die beschriebene Vielschichtstruktur auf einen integrierten Schaltkreis in Form eines ASIC als Substrat aufgebracht wird. Der Herstellungsprozeß erfolgt unter Zwischenschaltung einer Isolationsschicht und einer Metallbeschichtung. Die Schichtenfolge beim Aufdampfen ist dabei umgekehrt wie im Zusammenhang mit Fig. 1 bzw. Fig 3 beschrieben.

Gemäß Fig. 5 fällt dann das Licht von oben auf die Struktur ein. Je nach Ansteuerung der optischen Zelle durch die kristalline ASIC Struktur ergibt sich für jedes Pixelelement je nach angelegter Spannung ein unterschiedliches Spektralverhalten. Auf diese Weise kann das eingestrahlte Licht pixelweise auf seine RGB Bestandteile hin analysiert werden und das auf diese Weise gewandelte Lichtsignal elektrisch weiterverarbeitet werden.

## Patentansprüche

1. Photoempfindliches elektronisches Bauelement auf der Basis von amorphem Silizium und dessen Legierungen gebildet aus einer auf einem transparenten leitfähigen Oxid (TCO) abgeschiedenen Schichtenfolge, die aus zwei antiseriell zueinander angeordneten p-i-n bzw. n-i-p bzw. Schottkykontakt-Strukturen besteht, wobei im Bereich der vom transparenten Oxid aus ersten Struktur die von blauem Licht generierten Ladungsträger für eine erste Spannung und im Bereich der vom transparenten Oxid aus zweiten Struktur die von grünem bzw. rotem Licht generierten Ladungsträger für eine zweite bzw. dritte Spannung gesammelt werden, und wobei die eigenleitende Schicht der zweiten Struktur aus zwei Teilschichten aufgebaut ist,
**dadurch gekennzeichnet**, daß in der vom transparenten Oxid aus ersten Teilschicht (I) ein höheres und in der zweiten Teilschicht (II) ein demgegenüber mindestens um den Faktor 10 niedrigeres Produkt aus Ladungsträgerbeweglichkeit und Lebensdauer (µ-Tau-Produkt) vorliegt derart, daß die beiden Teilschichten (I,II) in Gegenwart eines elektrischen Feldes unterschiedliche Sammellängen für die Ladungsträger aufweisen dahingehend, daß in der ersten Teilschicht (I) vermehrt grünes und in der zweiten Teilschicht (II) vermehrt rotes Licht absorbiert wird.

2. Bauelement nach Anspruch 1,
**dadurch gekennzeichnet**, daß das Verhältnis der µ-Tau-Produkte in den beiden Teilschichten 1:10 bis 1:100 beträgt.

3. Bauelement nach einem der vorhergehenden Ansprüche,
**dadurch gekennzeichnet**, daß der Wert des µ-Tau-Produktes in der ersten Teilschicht zwischen 10⁻⁷cm²V⁻¹ und 10⁻⁶cm²V⁻¹ und in der zweiten Teilschicht zwischen 10⁻⁸cm²V⁻¹ und 10⁻⁷cm²V⁻¹ beträgt.

4. Bauelement nach einem der vorhergehenden Ansprüche,
**dadurch gekennzeichnet**, daß die Einstellung des µ-Tau-Produktes durch Beeinflussung der Ladungsträgerbeweglichkeit gegenüber eigenleitendem amorphen Sizilium durch Einbau von Fremdatomen, insbesondere a-Si_{X}Ge₍₁₋ₓ₎:H, erfolgt.

5. Bauelement nach einem der vorhergehenden Ansprüche,
**gekennzeichnet durch**, die auf ein Glassubstrat aufgebrachte Schichtenfolge:
(a) eine n-leitende a-Si:H Schicht
(b) eine erste eigenleitende a-Si:H Schicht
(c) eine p-leitende a-Si:H Schicht
(d) eine zweite eigenleitende a-Si:H Schicht, bestehend aus einer ersten Teilschicht mit höherem µ-Tau-Prdodukt und einer zweiten Teilschicht mit gegenüber der ersten Teilschicht niedrigerem µ-Tau-Produkt
(e) eine n-leitende a-Si:H Schicht.

6. Bauelement nach einem der vorhergehenden Ansprüche,
**gekennzeichnet durch**, die auf ein Glassubstrat aufgebrachte Schichtenfolge:
(a) eine p-leitende a-Si:H Schicht
(b) eine erste eigenleitende a-Si:H Schicht
(c) eine n-leitende a-Si:H Schicht
(d) eine zweite eigenleitende a-Si:H Schicht, bestehend aus einer ersten Teilschicht mit höherem µ-Tau-Prdodukt und einer zweiten Teilschicht mit gegenüber der ersten Teilschicht niedrigerem µ-Tau-Produkt
(e) eine p-leitende a-Si:H Schicht.

7. Bauelement nach einem der vorhergehenden Ansprüche,
**dadurch gekennzeichnet**, daß die Schicht aus dem transparenten leitfähigen Oxid (TCO) zwischen Glassubstrat und n-i-p-i-n bzw. p-i-n-i-p Schichtenfolge vorgesehen ist.

8. Bauelement nach einem der vorhergehenden Ansprüche,
**dadurch gekennzeichnet**, daß im Bereich mindestens einer eigenleitenden Schicht eine weitere eigenleitende Schicht aus a-Si(C):H mit erhöhtem Bandabstand vorgesehen ist.

9. Bauelement nach einem der vorhergehenden Ansprüche,
**dadurch gekennzeichnet**, daß anstelle einer a-Si:H eigenleitenden Schicht eine eigenleitende Schicht aus a-Si(C):H mit erhöhtem Bandabstand im Bereich von 1,72 bis 1,95 eV vorgesehen ist.

10. Bauelement nach einem der vorhergehenden Ansprüche,
**dadurch gekennzeichnet**, daß anstelle einer dotierten a-Si:H Schicht eine Schicht aus mikrokristallinem oder karboniertem amorphen Silizium vorgesehen ist.

11. Farbsensor unter Verwendung eines Bauelements nach einem der vorhergehenden Ansprüche,
**dadurch gekennzeichnet**, daß die das Bauelement bildende Schichtstruktur auf der Oberfläche eines integrierten Schaltkreises abgeschieden ist.

12. Farbsensor nach Anspruch 11,
**dadurch gekennzeichnet**, daß der integrierte Schaltkreis ein ASIC ist.

13. Farbsensor nach einem der vorhergehenden Ansprüche,
**dadurch gekennzeichnet**, daß als Trägersubstrat Quarz, Metall, Si-Wafer, GaAs oder Kunststoff verwendet werden.

14. Verfahren zur Herstellung eines photoempfindlichen elektronischen Bauelementes auf der Basis von amorphem Silizium mittels der PECVD-Technologie, bei dem auf ein transparentes, leitfähiges Oxid (TCO) eine Schichtenfolge aus einer ersten dotierten Schicht, einer ersten eigenleitenden Schicht, einer dotierten Zwischenschicht, einer zweiten eigenleitenden Schicht und einer dotierten Randschicht aufgebracht wird, wodurch zwei antiseriell zueinander angeordnete p-i-n bzw. n-i-p Übergänge ausgebildet werden, wobei mindestens eine der eigenleitenden Schichten aus zwei Teilschichten (I,II) gebildet wird, **dadurch gekennzeichnet**, daß diese Teilschichten durch Einbringen von Fremdatomen, insbesondere von Ge, derart unterschiedliche Beweglichkeiten aufweisen, daß die µ-Tau-Produkte in den beiden Teilschichten (I,II) mindestens um den Faktor 10 voreinander abweichen, wobei die Teilschicht mit dem höheren µ-Tau-Produkt vom transparenten leitfähigen Oxid (TCO) aus gesehen vorgeordnet ist.

15. Verfahren nach Anspruch 14,
**dadurch gekennzeichnet**, daß die Verhältnisse der µ-Tau-Produkte in den beiden Teilschichten zwischen 1:20 und 1:100 liegen.

## Claims

1. A photosensitive electronic component based on amorphous silicon and its alloys, with a layer sequence deposited on a transparent conductive oxide (TCO) comprising two, in respect to each other antiserially arranged, p-i-n or n-i-p or Schottky-contact structures, with, in the region of the first structure as viewed from the transparent oxide, the charge carriers generated by blue light being collected for a first voltage and in the area of the second structure as viewed from the transparent oxide the charge carriers generated by green or red light are collected for a second or third voltage, and with the intrinsically conducting layer of the second structure being constructed from two partial layers; characterized in that in the first partial layer (I) as viewed from the transparent oxide a higher product, and in the second partial layer (II) a product which compared to the first product is lower by at least a factor of 10, of charge carrier mobility and lifetime (µ-tau product) is present, such that the two partial layers (I, II) in the presence of an electrical field have different collection lengths for the charge carriers, to the effect that in the first partial layer (I) an increased amount of green light, and in the second partial layer (II) an increased amount of red light is absorbed.

2. A component according to claim 1, characterized in that the proportion of the µ-tau products in the two partial layers is 1:10 to 1:100.

3. A component according to one of the preceding claims, characterized in that the value of the µ-tau product in the first partial layer is between 10-⁷cm²V⁻¹ and 10⁻⁶cm²V⁻¹, and in the second partial layer between 10⁻⁸cm²V⁻¹ and 10⁻⁷cm²V⁻¹.

4. A component according to one of the preceding claims, characterized in that the setting of the µ-tau product occurs by influencing the charge carrier mobility in respect to the intrinsically conducting amorphous silicon, by incorporating foreign atoms, in particular a-SiₓGe₍₁₋ₓ₎:H.

5. A component according to one of the preceding claims, characterized by the layer sequence applied to a glass substrate:
(a) an n-conducting a-Si:H layer
(b) a first intrinsically conducting a-Si:H layer
(c) a p-conducting a-Si:H layer
(d) a second intrinsically conducting a-Si:H layer consisting of a first partial layer with a higher µ-tau product and a second partial layer with a lower µ-tau product in comparison with the first partial layer
(e) an n-conducting a-Si:H layer.

6. A component according to one of the preceding claims, characterized by the layer sequence applied to a glass substrate:
(a) a p-conducting a-Si:H layer
(b) a first intrinsically conducting a-Si:H layer
(c) an n-conducting a-Si:H layer
(d) a second intrinsically conducting a-Si:H layer consisting of a first partial layer with a higher µ-tau product and a second partial layer with a lower µ-tau product in comparison with the first partial layer
(e) a p-conducting a-Si:H layer.

7. A component according to one of the preceding claims, characterized in that the layer of the transparent conductive oxide (TCO) is provided between the glass substrate and the n-i-p-i-n or p-i-n-i-p layer sequence.

8. A component according to one of the preceding claims, characterized in that in the region of at least one intrinsically conducting layer a further intrinsically conducting layer of a-Si(C):H with an increased band gap is provided.

9. A component according to one of the preceding claims, characterized in that instead of an intrinsically conducting layer of a-Si:H an intrinsically conducting layer of a-Si(C):H with an increased band gap in the range of 1.72 to 1.95 eV is provided.

10. A component according to one of the preceding claims, characterized in that instead of a doped a-Si:H layer a layer of micro crystalline or carbonised amorphous silicon is provided.

11. A colour sensor using a component according to one of the preceding claims, characterized in that the sandwich structure forming the component is deposited on the surface of an integrated circuit.

12. A colour sensor according to claim 11, characterized in that the integrated circuit is an ASIC.

13. A colour sensor according to one of the preceding claims, characterized in that quartz, metal, Si-wafer, GaAs or plastic is used as a carrier substrate.

14. A process for the production of a photo sensitive electronic component based on amorphous silicon by means of PECVD technology, in which a layer sequence comprising a first doped layer, a first intrinsically conducting layer, a doped intermediate layer, a second intrinsically conducting layer and a doped barrier layer are placed on a transparent conductive oxide (TCO), whereby two, in respect to each other antiserially arranged, p-i-n or n-i-p junctions are formed, whereby at least one of the intrinsically conducting layers is constructed from two partial layers (I, II) characterized in that these partial layers on the basis of incorporating foreign atoms, in particular Ge, have such different mobilities that the µ-tau products in the two partial layers (I, II) differ from each other by at least a factor of 10, whereby the partial layer with the higher µ-tau product as viewed from the transparent conductive oxide (TCO), is in front.

15. A process according to claim 14, characterized in that the proportions of the µ-tau products in the two partial layers are between 1:20 and 1:100.

## Revendications

1. Composant électronique photosensible à base de silicium amorphe et d'alliages de silicium, constitué par une succession de couches déposée sur un oxyde transparent conducteur (TCO) et qui comprend deux structures p-i-n ou n-i-p ou à contact Schottky disposées l'une par rapport à l'autre selon un montage anti-série, et dans lequel des porteurs de charges, générés par la lumière bleue, s'accumulent dans la région de la première structure à partir de l'oxyde transparent, pour une première tension et les porteurs de charges générés par la lumière verte et par la lumière rouge s'accumulent dans la région de la seconde structure à partir de l'oxyde transparent, pour une seconde ou une troisième tension, et dans lequel la couche intrinsèque de la seconde structure est constituée de deux couches partielles, caractérisé en ce que le produit de la mobilité des porteurs de charges par la durée de vie (produit µ-tau) est plus élevé dans la première couche partielle (I) à partir de l'oxyde transparent et est inférieur d'au moins un facteur 10 dans la seconde couche partielle (II), à celui de la première couche partielle, de telle sorte que les deux couches partielles (I, II) possèdent, en présence d'un champ électrique, des longueurs différentes d'accumulation pour les porteurs de charges en ce sens qu'une lumière verte est absorbée d'une manière accrue dans la première couche partielle (I) et qu'une lumière rouge est absorbée d'une manière accrue dans la seconde couche partielle (II).

2. Composant selon la revendication 1, caractérisé en ce que le rapport des produits µ-tau dans les deux couches partielles est compris entre 1:10 et 1:100.

3. Composant selon l'une des revendications précédentes, caractérisé en ce que la valeur du produit µ-tau est comprise entre 10⁻⁷cm²V⁻¹ et 10⁻⁶cm²V⁻¹ dans la première couche partielle et entre 10⁻⁸cm²V⁻¹ et 10⁻⁷cm²V⁻¹ dans la seconde couche partielle.

4. Composant selon l'une des revendications précédentes, caractérisé en ce que le réglage du produit µ-tau est réalisé par influence de la mobilité des porteurs de charges par rapport à du silicium amorphe intrinsèque par insertion d'atomes étrangers, notamment du a-SiₓGe₍₁₋ₓ₎:H.

5. Composant selon l'une des revendications précédentes, caractérisé par la succession de couches déposée sur un substrat en verre :
(a) une couche de a-Si:H conductrice de type n,
(b) une première couche intrinsèque de a-Si:H,
(c) une couche conductrice de type p de a-Si:H,
(d) une seconde couche intrinsèque de a-Si:H, constituée par une première couche partielle possédant un produit µ-tau plus élevé et par une seconde couche partielle possédant un produit µ-tau plus faible que celui de la première couche partielle,
(e) une couche de a-Si:H conductrice de type n.

6. Composant selon l'une des revendications précédentes, caractérisé par la succession de couches déposée sur un substrat en verre :
(a) une couche de a-Si:H conductrice de type p,
(b) une première couche intrinsèque de a-Si:H,
(c) une couche de a-Si:H conductrice de type n,
(d) une seconde couche intrinsèque de a-Si:H, constituée par une première couche partielle possédant un produit µ-tau plus élevé et par une seconde couche partielle possédant un produit µ-tau plus faible que celui de la première couche partielle,
(e) une couche de a-Si:H conductrice de type p.

7. Composant selon l'une des revendications précédentes, caractérisé en ce que la couche formée de l'oxyde conducteur transparent (TCO) est disposée entre un substrat en verre et une succession de couches n-i-p-i-n ou p-i-n-i-p.

8. Composant selon l'une des revendications précédentes, caractérisé en ce qu'une autre couche intrinsèque formée de a-Si(C):H possédant un intervalle d'énergie entre bandes accru est prévue dans la région d'au moins une couche intrinsèque.

9. Composant selon l'une des revendications précédentes, caractérisé en ce qu'à la place d'une couche intrinsèque de a-Si:H, il est prévu une couche intrinsèque de a-Si(C):H, possédant un intervalle d'énergie entre bandes accru, dans la gamme de 1,72 à 1,95 eV.

10. Composant selon l'une des revendications précédentes, caractérisé en ce qu'à la place d'une couche de a-Si:H dopé, il est prévu une couche de silicium microcristallin ou de silicium amorphe carboné.

11. Capteur de couleurs utilisant un composant selon l'une des revendications précédentes, caractérisé en ce que la structure de couches constituant le composant est déposée sur la surface d'un circuit intégré.

12. Capteur de couleurs selon la revendication 11, caractérisé en ce que le circuit intégré est un circuit ASIC.

13. Capteur de couleurs selon l'une des revendications précédentes, caractérisé en ce qu'on utilise comme substrat de support du quartz, un métal, une pastille de Si, du GaAs ou une matière plastique.

14. Procédé pour fabriquer un composant électronique photosensible à base de silicium amorphe à l'aide de la technologie PECVD, selon lequel on dépose, sur un oxyde conducteur transparent (TCO), une succession de couches comprenant une première couche dopée, une première couche intrinsèque, une couche intermédiaire dopée, une seconde couche intrinsèque et une couche marginale dopée, en formant de ce fait deux jonctions p-i-n et n-i-p disposées l'une par rapport à l'autre selon un montage anti-série, et selon lequel au moins l'une des couches intrinsèques est formée de deux couches partielles (I, II), caractérisé en ce que ces couches partielles comportent, sous l'effet de l'introduction d'atomes étrangers, notamment de Ge, des mobilités différentes de telle sorte que les produits µ-tau dans les deux couches partielles (I, II) diffèrent l'un de l'autre au moins du facteur 10, la couche partielle possédant le facteur µ-tau le plus élevé étant disposée en avant lorsqu'on regarde à partir de la couche transparente conductrice (TCO).

15. Procédé selon la revendication 16, caractérisé en ce que les rapports des produits µ-tau dans les deux couches partielles sont compris entre 1:20 et 1:100.
